(19) **Europäisches Patentamt / European Patent Office / Office européen des brevets**

(11) **EP 3 913 434 A1**

(12) **EUROPEAN PATENT APPLICATION**

(43) Date of publication:
**24.11.2021 Bulletin 2021/47**

(51) Int Cl.:
**G03F 7/00** (2006.01)       **C08G 77/28** (2006.01)
**G03F 7/105** (2006.01)

(21) Application number: **21174427.1**

(22) Date of filing: **18.05.2021**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **19.05.2020   US 202063027247 P**

(71) Applicant: **Facebook Technologies, LLC**
**Menlo Park, CA 94025 (US)**

(72) Inventors:
• **WALLIN, Thomas John Farrell**
  **Kirkland (US)**
• **PAN, Wenyang**
  **Redmond (US)**

(74) Representative: **Murgitroyd & Company**
**Murgitroyd House**
**165-169 Scotland Street**
**Glasgow G5 8PL (GB)**

(54) **3D-PRINTING METHOD WITH THE USE OF THERMOCHROMIC ADDITIVES**

(57)   The disclosure provides methods and compositions for 3D printing using thermochromic additives. Thermochromic dyes change absorptivity with heat to selectively attenuate light transmission and control cure depth during 3D printing photopolymerization.

Fig. 1

**Description**

RELATED APPLICATIONS

This application claims the benefit of, and priority to, U.S. Provisional Patent Application Serial No. 63/027,247, filed May 19, 2020, incorporated by reference herein in its entirety.

FIELD

Thermochromic dyes change absorptivity with heat to selectively attenuate light transmission and control cure depth during photopolymerization. Additionally, thermochromics can attenuate light before polymerization to extend pot life of the liquid resins, and after polymerization to maintain material performance in photosensitive materials.

BACKGROUND

Vat polymerization 3D printing techniques (stereolithography [SLA], digital light processing [DLP], continuous liquid interface printing [CLIP], holographic printing, tomographic printing, 2-photon polymerization [2PP] etc.) can rapidly cure solid objects from within a vat of photopolymer resin. Such processing is particularly attractive for fabricating complex geometries with micron scaled features owing to the spatial-temporal resolution of light, the buoyant support provided by the liquid resin, and rapid deposition rates. In all of these processes, photoirradiation penetrates the liquid resin in select regions, initiating photochemical reactions. Ideally, this irradiation continues until the cumulative photodosage exceeds a critical value necessary for gelation (solidification) of the resin within the intended voxels. The optical properties of the resin (absorptivity) must be tuned so that incident photoirradiation is attenuated at an appropriate rate. Too little attenuation results in "cure through" where areas in planes beyond the target voxels receive a sufficient photodosage to gel. Too much attenuation limits the penetration depth of light in the resin, requiring long exposures and limiting the layer height of each build step to drastically increase build times for large parts.

Additionally, many photopolymer resins show photodegradation after polymerization. The printed objects contain unreacted precursors (monomers, oligomers, polymers, and photoinitiators) that can continue to react with ambient exposure to sunlight. This can result in embrittlement of the material as additional reactions change the polymer microstructure (e.g. crosslinking, chain scission, or chain backbiting reactions).

According to a first aspect of the present invention there is provided a method of 3D printing an object, comprising: providing a resin precursor mixture comprising a crosslinkable or polymerizable species, and a thermochromic species; and contacting a first portion of the resin precursor mixture with an actinic radiation; wherein upon contacting the portion of resin precursor mixture with the actinic radiation, a portion of the crosslinkable or polymerizable species in the resin precursor mixture cures to provide a portion of the object.

Preferably, the method further comprises modulating the temperature of a second portion of the resin precursor mixture.

Preferably, the temperature is modulated by contacting the second portion of the resin precursor mixture with a thermal radiation.

Preferably, the first portion of the resin precursor mixture and the second portion of the resin precursor mixture are substantially overlapped.

Preferably, the first portion of the resin precursor mixture and the second portion of the resin precursor mixture are each independently characterized by a cure depth dimension.

Preferably, the overlap between the first portion of the resin precursor mixture and the second portion of the resin precursor mixture is between about 50% and 100%.

Preferably, the resin precursor mixture has a viscosity before curing of 10 Pa·s or less.

Preferably, the resin precursor mixture comprises a first siloxane monomer, a first siloxane oligomer, or a first siloxane polymer, the siloxane comprising a plurality of thiol groups.

Preferably, the resin precursor mixture comprises a second siloxane monomer, a second siloxane oligomer, or a second siloxane polymer, the siloxane comprising a plurality of unsaturated carbon-carbon bonds.

Preferably, the resin precursor mixture comprises one or more of a hotoinitiator and a catalyst.

Preferably, the resin precursor mixture comprises a non-reactive diluent.

Preferably, the resin precursor mixture comprises a thermochromic additive.

BRIEF DESCRIPTION OF THE DRAWINGS

The patent or application file contains at least one drawing executed in color. Copies of this patent or patent application publication with color drawing(s) will be provided by the Office upon request and payment of the necessary fee.

For a better understanding of the various described embodiments, reference should be made to the Description of Embodiments below, in conjunction with the following drawings in which like reference numerals refer to corresponding parts throughout the figures and specification.

Figures 1 illustrates a simplified stereolithography printer in accordance with some embodiments.
Figures 2A and 2B illustrate the mechanism of thermochromic dyes impact on cure depth during 3D printing.

DETAILED DESCRIPTION

High resolution printing via vat polymerization requires proper control of the depth of photocure. Highly absorptive resins possess small cure depths which enable high resolution, but often require long exposures to build objects of appreciable size. Highly transparent resins exhibit larger cure depths which hinder resolution but enable rapid printing. In conventional resins, the absorptivity is static during printing. Further, photopolymers often contain photosensitive groups even after printing. Ambient light can often penetrate these bodies and initiate reactions that alter the polymer network and threaten material performance.

The cure depth is typically modified by adding absorptive species (chemical or physical) that vary the absorptivity (a) of a resin. Alternatively, the photodosage provided by the printer's light source ($H_{e,0}$) is manipulated to control cure depth ($C_d$). For post-print stability, common resins often include absorptive species (to attenuate light) or radical scavengers (to preferentially remove photo-generated radical species that propagate reactions). These strategies would slow down the photopolymerization reactions and lead to slower reaction kinetics during printing. Other alternatives could be to coat the object with an absorptive layer post print or extract these unreacted components via solvent.

Reference will now be made to embodiments, examples of which are illustrated in the accompanying drawings. In the following description, numerous specific details are set forth in order to provide an understanding of the various described embodiments. However, it will be apparent to one of ordinary skill in the art that the various described embodiments may be practiced without these specific details. In other instances, well-known methods, procedures, components, circuits, and networks have not been described in detail so as not to unnecessarily obscure aspects of the embodiments.

Definitions

The terminology used in the description of the various described embodiments herein is for the purpose of describing particular embodiments only and is not intended to be limiting. As used in the description of the various described embodiments and the appended claims, the singular forms "a," "an," and "the" are intended to include the plural forms as well, unless the context clearly indicates otherwise. It will also be understood that the term "and/or" as used herein refers to and encompasses any and all possible combinations of one or more of the associated listed items. It will be further understood that the terms "includes," "including," "comprises," and/or "comprising," when used in this specification, specify the presence of stated features, steps, operations, elements, and/or components, but do not preclude the presence or addition of one or more other features, steps, operations, elements, components, and/or groups thereof.

As used herein, the term "if' means "when" or "upon" or "in response to determining" or "in response to detecting" or "in accordance with a determination that," depending on the context. Similarly, the phrase "if it is determined" or "if [a stated condition or event] is detected" means "upon determining" or "in response to determining" or "upon detecting [the stated condition or event]" or "in response to detecting [the stated condition or event]" or "in accordance with a determination that [a stated condition or event] is detected," depending on the context.

As used herein, "photodosage" ($H_e$) refers to the product of photoirradiation power and exposure time) provided by the printer.

As used herein, "critical photodosage for gelation" ($H_{e,gelation}$) refers to the photodosage where the polymer network reaches percolation and solidifies.

As used herein, "absorptivity" (A) refers to the Beer-Lamberts Law A = abc, where a is the absorptivity constant. Absorptivity is a quantitative measurement of the ability of a material to absorb (attenuate) light. It is the wavelength dependent; b is the path length, and c is the concentration.

As used herein, "cure depth" ($C_d$) refers to the max distance from the resin-light interface that the resin solidifies at a given photodosage.

There is a balance between the photodosage provided by the printer, the critical photodosage for gelation, the absorptivity of the resin, and cure depth. In conventional systems, it is often useful to characterize the interplay of these factors by generating a "working curve" for the resin, which is a plot of $C_d$ v. $Log\ H_e$.

As light penetrates the resin, it is absorbed according to Beer-Lambert law. Eventually the irradiation energy ($H_e$) of light falls below a critical value needed to initiate enough polymerization for gelation. This depth is called the "cure depth," or $C_d$. This data fits to Equation 1:

$$C_d = \frac{1}{ac} \log \frac{H_{e,0}}{H_{e,gelation}} = \frac{1}{ac} \left[ \log H_{e,0} \right] - \frac{1}{ac} \log H_{e,gelation} \quad (eq.1)$$

where $a$ is the absorptivity constant from the Beer-Lambert Law, $c$ is the concentration of absorbing species from the Beer-Lambert Law, $H_{e,0}$ is the photodosage at the resins interface and $H_{e,gelation}$ is the critical photodosage for gelation. Without wishing to be bound by any particular theory, for rapid build speeds (printing large areas at low resolution), it is believed that it would be beneficial to maximize cure depth. For high resolution printing, it would be best to minimize cure depth.

For a given conventional resin, $ac$ and $H_{e,gelation}$ are static (though these can be varied by reformulating the resin). Thus, cure depth is controlled by modulating the irradiative energy provided by the printer's light source ($H_{e,0}$). This strategy only permits moving up or down the working curve, it does not change slope or intercept. The implications of such strategies for tomographic and holographic printing are particularly restrictive. Voided structures become challenging to obtain; these designs require properly modulating exposure such that adjacent internal voxels receives dissimilar dosages.

Thermochromics dyes can vary absorptivity of a material with temperature. Such materials are now commercially available with tunable properties (color or spectrum of absorption, onset temperature of color change, reversibility of color change). In some embodiments, and without wishing to be bound by any particular theory, when incorporated into a photopolymer resin, thermochromics allow for dynamic control of the working curve by making the absorptivity, $a$, a function of temperature, T.

$$C_d(T) = \frac{1}{a(T)c} \log \frac{H_{e,0}}{H_{e,gelation}} = \frac{1}{a(T)c} \left[ \log H_{e,0} \right] - \frac{1}{a(T)c} \log H_{e,gelation} \quad (eq.2)$$

When used in conjunction with a printer that varies temperature of the resin, thermochromics offer a way to dynamically change the working curve of a resin. Additionally, many 3D printed photopolymers exhibit photodegradation after printing, owing to unreacted photosensitive species incorporated into the part. In some embodiments, a method to minimize photodegradation is to limit the penetration depth of ambient light (e.g., add dyes to the precursors so that the material has a high absorptivity). The inclusion of traditional absorptive species in the resin alter the working curve and can lead to slow print speeds. By using reversible thermochromic dyes in the resin, the absorptivity during printing (at elevated temperatures) could be much lower than the post-print absorptivity of the part. This enables rapid print speeds and photo stability.

As will be described in more detail herein, a resin precursor mixture is configured for use in 3D printers. More specifically, the resin precursor mixture has a viscosity suitable for 3D printers, which typically require resins to have viscosities around (or below) approximately 5 Pa·s (up to 10 Pa·s is suitable for some 3D printers). Additionally, a viscosity of the resin precursor mixture can be tailored to a specific 3D printer, as described herein.

In some embodiments, a first polymer component in the resin precursor mixture includes one or more functional groups with unsaturated carbon-carbon bonds, aside from the vinyl groups. These other functional groups with unsaturated carbon-carbon bonds can include acrylate, vinyl ether, methacrylate, allyl, and the like. For ease of discussion, the first polymer component is sometimes referred to herein as a "vinyl polymer component." One skilled in the art will appreciate that "vinyl" in the discussion below may be replaced (or supplemented) with various other functional groups with unsaturated carbon-carbon bonds, such as the examples provided above. Other polymerizable or crosslinkable groups can likewise be used, e.g., epoxy groups. The vinyl polymer component includes a plurality of vinyl groups, which can be terminal groups. The vinyl groups can undergo an alkyl hydrothiolation reaction (e.g., in response to being exposed to actinic radiation) or the vinyl groups can undergo alkylation (e.g., in response to being exposed to actinic radiation). In some embodiments, the vinyl polymer component is an elastomer. In such embodiments, the vinyl polymer component has 2 to 30 vinyl groups, including all integer number of vinyl groups and ranges therebetween.

In some embodiments, the vinyl polymer component can be a siloxane polymer comprising a plurality of vinyl groups. The vinyl groups can be terminal vinyl groups, pendant vinyl groups, or a combination thereof. Moreover, the vinyl groups can be randomly distributed or distributed in an ordered manner on individual siloxane polymer chains. Further, the siloxane polymer comprising a plurality of vinyl groups can be linear or branched. In addition, the siloxane polymer comprising a plurality of vinyl groups can have a molecular weight (Mn or Mw) of 186 g/mol to 50,000 g/mol, including all integer g/mol values and ranges there between. In another example, the siloxane polymer can have a molecular weight (Mn or Mw) of 186 g/mol to 175,000 g/mol, including all integer g/mol values and ranges there between.

The second polymer component is sometimes referred to herein as a "thiol polymer component." The thiol polymer component can include a plurality of thiol groups. The thiol groups can be terminal groups. The thiol polymer component and its thiol groups can be referred to as mercapto polymer components and mercaptan groups, respectively. The thiol groups can undergo an alkyl hydrothiolation reaction (e.g., in response to being exposed to actinic radiation). In some embodiments, the thiol polymer component is an elastomer. In such embodiments, the thiol polymer component can have 2 to 30 thiol groups, including all integer number of thiol groups and ranges therebetween.

In some embodiments, the thiol polymer component can be a siloxane polymer comprising a plurality of thiol groups. In one example, the siloxane polymer is a (mercaptoalkyl)methylsiloxane-dimethylsiloxane copolymer, where, the alkyl group is a C1 to C11 alkyl group. A non-limiting example of a (mercaptoalkyl)methylsiloxane-dimethylsiloxane copolymer is mercaptopropyl(methylsiloxane)-dimethylsiloxane copolymer. The thiol groups can be terminal groups, pendant groups, or a combination thereof. The thiol groups can be randomly distributed or distributed in an ordered manner on the individual siloxane polymer chains. The siloxane polymer comprising a plurality of thiol groups can be linear or branched. In addition, the siloxane polymer comprising a plurality of thiol groups can have a molecular weight (Mn or Mw) of 186 g/mol to 50,000 g/mol, including all 0.1 g/mol values and ranges therebetween. In another example, the siloxane polymer comprising a plurality of thiol groups can have a molecular weight (Mn or Mw) of 186 g/mol to 175,000 g/mol, including all 0.1 g/mol values and ranges therebetween. In another example, the siloxane polymer comprising a plurality of thiol groups can have a molecular weight (Mn or Mw) of 268 g/mol to 50,000 g/mol, including all 0.1 g/mol values and ranges therebetween. In another example, the siloxane polymer can have a molecular weight (Mn or Mw) of 268 g/mol to 175,000 g/mol, including all 0.1 g/mol values and ranges therebetween.

The thiol polymer component (e.g., a siloxane polymer comprising a plurality of thiol groups) can have various amounts of thiol groups. In various examples, the thiol polymer component has 0.1-6 mol% thiol groups, including all 0.1 mol% values and ranges therebetween. In other examples, the thiol polymer component has 0.1-5 mol%, 0.1-4.9 mol%, 0.1-4.5 mol% thiol groups, 0.1-4 mol%, or 0.1-3 mol% thiol groups. In other examples, the thiol polymer component has 0.5-5 mol%, 0.5-4.9 mol%, 0.5-4.5 mol% thiol groups, 0.5-4 mol%, or 0.5-3 mol% thiol groups. In some embodiments, the thiol polymer component has between 0.1-10 mol% thiol groups, including all 0.1 mol% values and ranges therebetween. In some embodiments, the thiol polymer component has between 0.1-100 mol% thiol groups, including all 0.1 mol% values and ranges therebetween.

In some embodiments, the first polymer component and/or the second polymer component can have one or more non-reactive side groups (e.g., groups that do not react in a reaction used to pattern the polymer composition). Examples of non-reactive side groups include, but are not limited to, alkyl groups and substituted alkyl groups such as, for example, methyl, ethyl, propyl, phenyl, and trifluoropropyl groups.

The resin precursor mixture can include a plurality of different vinyl polymer components and/or a plurality of thiol polymer components. In addition, the resin precursor mixture can include linear and/or branched vinyl polymer components and/or linear or branched thiol polymer components. It is desirable that the resin precursor mixture include at least one branched monomer unit (e.g., one or more branched vinyl polymer component and/or one or more branched thiol polymer component) which can form a network structure (e.g., the first polymer network). It is considered that by using different combinations of linear and/or branched polymer components polymerized materials (e.g., 3D printed structures) can have different properties (e.g., mechanical, optical, and chemical properties).

The amount of vinyl polymer component(s) and thiol polymer component(s) can vary. The individual polymer components can be present at 0.5% to 99.5 % by weight, including all 0.1 % values and ranges therebetween. In various examples, the vinyl polymer component(s) are present at 3% to 85 % by weight and/or the thiol polymer component(s) are present at 15% to 97 % by weight. In these examples, the stoichiometric ratio of thiol groups to vinyl groups in the resin precursor mixture 101 is 1:1. In various other examples, the stoichiometric ratio of thiol groups to vinyl groups in the resin precursor mixture is from 26:1 to 1:26, 20:1 to 1:20, 15:1 to 1:15, 10:1 to 1:10, 5:1 to 1:5, 4:1 to 1:4, 3:1 to 1:3, or 2:1 to 1:2. These changes can yield different mechanical properties by affecting, for example, the crosslink density, distance between crosslinks, and degree of polymerization for the printed material.

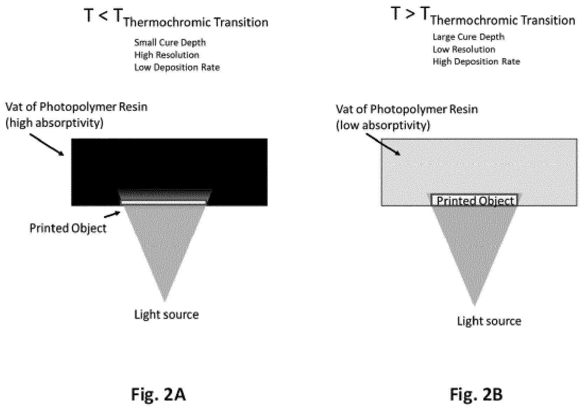

In some embodiments, the thiol polymer component is a poly-(mercaptopropyl)methylsiloxane-co-dimethylsiloxane polymer. In various examples, this polymer system has 2-3 mole% or 4-6 mole% mercaptopropyl groups with a total molecular weight of 6000-8000. The pendant mercaptopropyl groups are located randomly among the siloxane backbone. For example, the alkenes used in the thiolene chemistry are low viscosity polydimethylsiloxanes terminated on both ends by vinyl (-CH=CH2) groups with total molecular weights (Mn) of, for example, 186, 500, 6000, 17200, or 43000. These components are added in, for example, a 1:1 stoichiometric ratio of mercaptopropyl to vinyl groups depending on the desired mechanical properties of the resulting object (e.g., 3D Printed Part 206, Figure 2A). To this blend, a photoinitiator (e.g., 10% by weight of a 100 mg/mL diphenyl(2,4,6-trimethylbenzoyl)phosphine oxide in toluene) is added. Centrifugal mixing at, for example, 2000 rpm for 30 seconds provides a homogenous mixture, particularly for the high molecular weight components. A small amount (0.5% by weight) of absorptive species, like Sudan Red G, can be added as a photoblocker to limit cure depth to the desired build layer height.

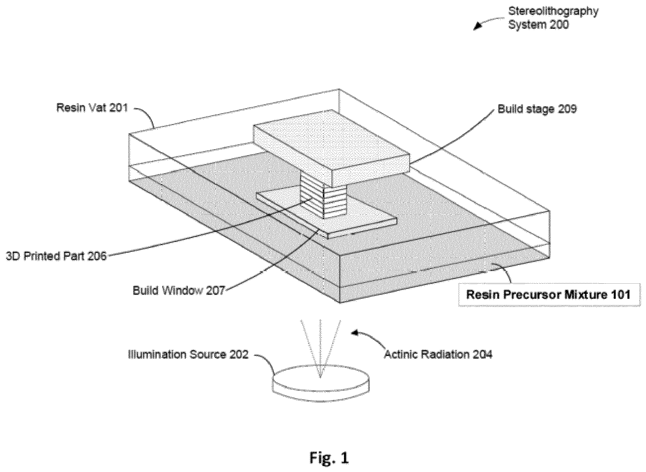

Various photoinitiators can be used, along with various mixtures of photoinitiators. The chemistry of the materials in the resin precursor mixture, and finished polymer, is not dependent on the type of or specific photoinitiator used. It is desirable that the photoinitiator and polymer components are at least partially miscible in each other or a suitable solvent system. It is desirable that the absorption of the photoinitiator overlap with the wavelength (e.g., 300 to 800 nm) of the radiation source (e.g., illumination source 202, Figure 1) used to photocure the polymer composition. Examples of photoinitiators include, but are not limited to, UV Type I photoinitiators, UV Type II, and visible photoinitiators. Examples of UV Type I photoinitiators include, but are not limited to, benzoin ethers, benzyl ketals, α-dialkoxyacetophenones, α-hydroxy-alkyl-phenones, α-amino alkyl-phenones, acyl-phosphine oxides, and derivatives thereof. Examples of UV Type II photoinitiators include, but are not limited to, include benzo-phenones/amines, thio-xanthones/amines, and derivatives thereof. Examples of visible photoinitiators include, but are not limited to titanocenes, flavins and derivatives thereof. Photoinitiator(s) can be present at various amounts in the compositions. In various examples, photoinitiator(s) are present in the polymer composition at 0.01 to 10% by weight, including all 0.01 % values and ranges therebetween, based on the weight of polymer components and photoinitiator(s) in a composition.

The resin precursor mixture can further include one or more solvents (e.g., non-reactive diluents). Examples of solvents include, but are not limited to, toluene, tetrahydrofuran, hexane, acetone, ethanol, water, dimethyl sulfoxide, pentane, cyclopentane, cyclohexane, benzene, chloroform, diethyl ether, dichloromethane, ethyl acetate, dimethylformamide, methanol, isopropanol, n-propanol, and butanol. In some embodiments, the one or more non-reactive diluents are up to 80% by weight of the blended resin. Solvents can be used to improve mixability of components in the blended resin.

The resin precursor mixture can further include one or more additives (e.g., solid particles). Examples of additives include, but are not limited to, diluents, non-reactive additives, nanoparticles, absorptive compounds, and combinations thereof. For example, an absorptive compound is a dye, which, if they absorb in the spectral range used to polymerize the polymer composition can be photoblockers, such as, for example, Sudan Red G. It is desirable that the additives be soluble in the blended resin. Examples of additives include, but are not limited to, metallic nanoparticles such as, for example, iron, gold, silver and platinum, oxide nanoparticles such as for example, iron oxide ($Fe_3O_4$ and/or $Fe_2O_3$), silica ($SiO_2$), and titania ($TiO_2$), diluents such as, for example, silicone fluids (e.g., hexamethyldisiloxane and polydimethysiloxane), non-reactive additives or fillers such as, for example, calcium carbonates, silica, and clays, absorptive compounds such as, for example, pigments (e.g., pigments sold under the commercial name "Silc Pig" such as, for example, titanium dioxide, unbleached titanium, yellow iron oxide, mixed oxides, red iron oxide, black iron oxide, quinacridone magenta, anthraquinone red, pyrrole red, disazo scarlet, azo orange, arylide yellow, quinophthalone yellow, chromium oxide green, phthalocyanine cyan, phthalocyanine blue, cobalt blue, carbazole violet and carbon black). In some embodiments, the one or more additives are up to 50% by weight of the blended resin.

The resin precursor mixture can further include one or more thermochromic additives, including, without limitation, spirolactones, fluorans, spiropyrans, and fulgides. In some embodiments, such thermochromic additives can be selected from diphenylmethane phthalide derivatives, phenylindolylphthalide derivatives, indolylphthalide derivatives, diphenylmethane azaphthalide derivatives, phenylindolylazaphthalide derivatives, fluoran derivatives, styrynoquinoline derivatives, and diaza-rhodamine lactone derivatives which can include: 3,3-bis(p-dimethylaminophenyl)-6-dimethylaminophthalide; 3-(4-diethylaminophenyl)-3-(1-ethyl-2-methylindol-3-yl) phthalide; 3,3-bis(1-n-butyl-2-methylindol-3-yl)phthalide; 3,3-bis(2-ethoxy-4-diethylaminophenyl)-4-azaphthalide; 3-[2-ethoxy-4-(N-ethylanilino)phenyl]-3-(1-ethyl-2-methylindol-3-yl)-4-azaphthalide; 3,6-dimethoxyfluoran; 3,6-di-n-butoxyfluoran; 2-methyl-6-(N-ethyl-N-p-tolylamino)fluoran; 3-chloro-6-cyclohexylaminofluoran; 2-methyl-6-cyclohexylaminofluoran; 2-(2-chloroanilino)-6-di-n-butylamino fluoran; 2-(3-trifluoromethylanilino)-6-diethylaminofluoran; 2-(N-methylanilino)-6-(N-ethyl-N-p-tolylamino) fluoran, 1,3-dimethyl-6-diethylaminofluoran; 2-chloro-3-methyl-6-diethylamino fluoran; 2-anilino-3-methyl-6-diethylaminofluoran; 2-anilino-3-methyl-6-di-n-butylamino fluoran; 2-xylidino-3-methyl-6-diethylaminofluoran; 1,2-benzo-6-diethylaminofluoran; 1,2-benzo-6-(N-ethyl-N-isobutylamino)fluoran, 1,2-benzo-6-(N-ethyl-N-isoamylamino)fluoran; 2-(3-methoxy-4-dodecoxystyryl)quinoline; spiro[5H-(1)benzopyrano(2,3-d)pyrimidine-5,1'(3'H)isobenzofuran]-3'-one; 2-(diethylamino)-8-(diethylamino)-4-methyl-spiro[5H-(1)benzopyrano(2,3-d)pyrimidine-5,1'(3'H)isobenzofuran]-3'-one; 2-(di-n-butylamino)-8-(di-n-butylamino)-4-methyl-spiro[5H-(1)benzopyrano(2,3-d)pyrimidine-5,1'(3'H)isobenzofuran]-3'-one; 2-(di-n-butylamino)-8-(diethylamino)-4-methyl-spiro[5H-(1)benzopyrano(2,3-d)pyrimidine-5,1'(3'H)isobenzofuran]-3'-one; 2-(di-n-butylamino)-8(N-ethyl-N-isoamylamino)-4-methyl-spiro[5H-(1)benzopyrano(2,3-d)pyrimidine-5,1'(3'H)isobenzofuran]-3'-one; and 2-(di-n-butylamino)-8-(di-n-butylamino)-4-phenyl and trisubstituted pyridines.

As shown in Figure 1, the stereolithography printer 200 includes a resin vat 201 holding the blended resin. The stereolithography printer 200 also includes a build window 207 and an illumination source 202 directed at a first surface of the build window 207. The build window 207 is a solid, translucent layer that allows light to enter the resin vat and photopolymerize the resin precursor mixture 101. The resin precursor mixture 101 covers the second surface of the build window 207, and when the illumination source 202 directs actinic radiation 204 at the first surface of the build window 207, the actinic radiation 204 passes through the build window 207 and polymerizes a thin layer of the resin precursor mixture on the second surface of the build window 207. Specifically, the actinic radiation 204 partially polymerizes the first base component 102 in the resin precursor mixture and the second base component slowly polymerizes thereafter, via a catalyst. The cured material preferably adheres to the build stage 209 (and/or previously cured material), and the build stage 209 is configured to move away from the build window 207 after the illumination source 202 directs the actinic radiation 204 at the first surface of the build window 207. For example, the build stage 209 is raised approximately a thickness of the thin layer, and the resin precursor mixture again covers the second surface of the build window 207. The process described above is repeated until the 3D printed part 206 is formed. As shown, the 3D printed part 206 is composed of multiple layers.

It is noted that Figure 1 covers a "bottom-up" stereolithography printer. The resin precursor mixture described herein performs equally well in "top-down" stereolithography printers, where UV radiation is transmitted through the air-liquid interface at the top of a vat of liquid resin and the build stage is lowered down into the vat after each exposure step.

In some embodiments, a viscosity of the resin precursor mixture is adjusted (i.e., tailored) to a particular 3D printer. For example, various solvents and/or additives can be added to the resin precursor mixture so that the viscosity of the resin precursor mixture is suitable. Moreover, respective percentages of the first base component and the second base component (as well as their respective polymer components) in the resin precursor mixture can be adjusted to achieve the desired viscosity. Additionally, in some embodiments, when the resin precursor mixture is deposited by the ink-based 3D printer, an aggressive photoinitiator is included in the resin precursor mixture (e.g., the photoinitiator reduces a gel transition time of the first base component). In this way, bleeding of ink deposited by the print head can be further reduced.

In some instances, a viscosity greater than 5 Pa·s is an upper limit for stereolithography. In some other instances, a viscosity greater than 10 Pa·s is an upper limit for stereolithography. Whichever the case, in those instances where the viscosity of the resin precursor mixture is impractical for printing, shear thinning or other strategies can be applied to lower viscosity for printing. Additionally, a gel dosage greater than 1600 mW cm$^{-2}$, which corresponds to approximately 80 seconds of exposure per layer in conventional stereolithography, can be impractical for printing.

In some embodiments, the resin precursor mixture further includes a photoinitiator. The photoinitiator allows the resin precursor mixture to rapidly polymerize into a solid object during a 3D printing operation. In some embodiments, a first photoinitiator is used when a first 3D printing process is used (e.g., stereolithography) and a second photoinitiator is used when a second 3D printing process is used (e.g., fused deposition modeling, inkjet 3D printing, and the like), where the second photoinitiator polymerizes the resin precursor mixture faster than the first photoinitiator. Various photoinitiators can be used, along with various mixtures of photoinitiators. The chemistry of the materials in the blended resin, and finished polymer, is not dependent on the type of or specific photoinitiator used. Photoinitiators are discussed in further detail above with reference to Figure 1A.

In some embodiments, the first base component is photocurable and includes (i) a first siloxane polymer comprising a plurality of thiol groups (e.g., second polymer component) and (ii) a second siloxane polymer comprising a plurality of functional groups with unsaturated carbon-carbon bonds (e.g., first polymer component). In some embodiments, the second siloxane polymer includes a plurality of vinyl groups. Alternatively or in addition, in some embodiments, the second siloxane polymer includes a plurality of acrylate groups, vinyl ether groups, methacrylate groups, allyl groups, or the like. In some embodiments, the first base component includes a plurality of first siloxane polymer components and/or a plurality of different (or the same) second siloxane polymer components. For example, the first base component may include one or more acrylate groups and one or more vinyl groups (or some other combination of siloxane polymers) for the second siloxane polymer components.

In some embodiments, the first siloxane polymer has a molecular weight below approximately 500,000 daltons. In some embodiments, the first siloxane polymer has a molecular weight below approximately 150,000 daltons. In some embodiments, the first siloxane polymer has a molecular weight below approximately 50,000 daltons. Similarly, in some embodiments, the second siloxane polymer has a molecular weight below approximately 500,000 daltons. In some embodiments, the second siloxane polymer has a molecular weight below approximately 150,000 daltons. In some embodiments, the second siloxane polymer has a molecular weight below approximately 50,000 daltons.

In some embodiments, the first siloxane polymer has a molar thiol density between 2% and 5%, including all 0.1 mol% values and ranges therebetween. In some embodiments, the first siloxane polymer has a molar thiol density between .1% and 10%, including all 0.1 mol% values and ranges therebetween. In some embodiments, the first siloxane polymer has a molar thiol density between .1% and 100%, including all 0.1 mol% values and ranges therebetween.

In some embodiments, the second base component has less than 1% by weight of vinyl groups (and/or any of the functional groups with unsaturated carbon-carbon bonds discussed above) and/or thiol groups to minimize inter-network crosslinking with the first base component during polymerization. In this way, the resin precursor mixture can be made into final parts composes of an interpenetrating polymer network (discussed in more detail below).

In some embodiments, the second base component is condensation curable via the catalyst. A condensation reaction experienced by the second base component can be a step-addition reaction that produces an addition product and release a byproduct, such as water, ethanol, or various other specifies. Furthermore, the second base component includes a plurality of crosslinkable groups distinct from the plurality of thiol groups and the plurality of functional groups with unsaturated carbon-carbon bonds of the first base component. With such a composition, during polymerization of the first base component, the plurality of thiol groups and the plurality of functional groups with unsaturated carbon-carbon bonds do not compete with the plurality of crosslinkable groups to form chemical crosslinks. This is possible because the plurality of thiol groups and the plurality of functional groups with unsaturated carbon-carbon bonds undergo a chemically orthogonal crosslinking reaction, relative to a crosslinking reaction undergone by the plurality of crosslinkable groups.

The second base component can include a third siloxane polymer comprising a plurality of silanol groups (and/or other multifunctional siloxane crosslinkers). Example multifunctional crosslinkers include alcohol, acetoxy, epoxy, oxime, alkoxy, hydride, and amine based systems (and the like). As mentioned above, the second base component provides mechanical robustness to a finished, fully cured part. For example, the second base component provides excellent strength, elongation, and/or toughness mechanical performance over a range of elastic moduli spanning orders of magnitude (250 kPa - 2 MPa). In some embodiments, the second base component is a Room-Temperature-Vulcanizing (RTV) silicone. As an example, the RTV silicones used can be from the MOLDMAX series produced by REYNOLDS ADVANCED MATERIALS. It is noted that various other RTV silicones can also be used.

In some embodiments, the resin precursor mixture has a viscosity below approximately 10 pascal-seconds. In some embodiments, the resin precursor mixture has a viscosity of approximately 5 pascal-seconds. In some embodiments, the resin precursor mixture has a viscosity between 0.01 pascal-seconds to 10 pascal-seconds, including all 0.1 values and ranges therebetween. In some embodiments, the resin precursor mixture has the added benefit of being thixotropic which helps maintain a desired viscosity during the printing process (e.g., the resin does not build up on the print head over the course of a printing operation (or multiple printing operations) due to shearing imposed on the resin during the printing process). In some embodiments, the resin precursor mixture may be printed at elevated temperatures which reduces the viscosity and increases the rate of reaction of the first base component.

In some embodiments, the first base component is between 10% to 60% by weight of the resin precursor mixture, including all 0.1 values and ranges therebetween. In some embodiments, the first base component is between 15% to 35% by weight of the blended resin, including all 0.1 values and ranges therebetween. In some embodiments, the first base component is approximately 15% by weight of the blended resin. In some embodiments, the first base component is between 10% to 99% by weight of the blended resin, including all 0.1 values and ranges therebetween. These changes can yield different mechanical properties by affecting, for example, the crosslink density of the first base component (and the second base component), distance between crosslinks, and degree of polymerization for the printed material.

In some embodiments, the resin precursor mixture further includes one or more non-reactive diluents, and the one or more non-reactive diluents are up to 80% by weight of the blended resin. Non-reactive diluents (referred to as "solvents") are discussed in further detail above.

In some embodiments, the resin precursor mixture further includes one or more solid particles, and the one or more solid particulates are up to 50% by weight of the blended resin. Solid particles (referred to as "additives") are discussed in further detail above.

Although some of various drawings illustrate a number of logical stages in a particular order, stages which are not order dependent may be reordered and other stages may be combined or broken out. While some reordering or other groupings are specifically mentioned, others will be obvious to those of ordinary skill in the art, so the ordering and groupings presented herein are not an exhaustive list of alternatives. Moreover, it should be recognized that the stages could be implemented in hardware, firmware, software, or any combination thereof.

The foregoing description, for purpose of explanation, has been described with reference to specific embodiments. However, the illustrative discussions above are not intended to be exhaustive or to limit the scope of the claims to the precise forms disclosed. Many modifications and variations are possible in view of the above teachings. The embodiments were chosen in order to best explain the principles underlying the claims and their practical applications, to thereby enable others skilled in the art to best use the embodiments with various modifications as are suited to the particular uses contemplated.

The following clauses describe certain embodiments.

Clause 1. A method of 3D printing an object, comprising: providing a resin precursor mixture comprising a crosslinkable or polymerizable species, and a thermochromic species; and contacting a first portion of the resin precursor mixture with an actinic radiation; wherein upon contacting the portion of resin precursor mixture with the actinic radiation, a portion of the crosslinkable or polymerizable species in the resin precursor mixture cures to provide a portion of the object.

Clause 2. The method of clause 1, further comprising modulating the temperature of a second portion of the resin precursor mixture.

Clause 3. The method of clause 2, wherein the temperature is modulated by contacting the second portion of the resin precursor mixture with a thermal radiation.

Clause 4a. The method of clause 2 or clause 3, wherein the first portion of the resin precursor mixture and the second portion of the resin precursor mixture are substantially overlapped.

Clause 4b. The method of clause 2 or clause 3, wherein the first portion of the resin precursor mixture and the second portion of the resin precursor mixture are overlapped by about 1%, about 2%, about 3%, about 4%, about 5%, about 6%, about 7%, about 8%, about 9%, about 10%, about 11%, about 12%, about 13%, about 14%, about 15%, about 16%, about 17%, about 18%, about 19%, about 20%, about 21%, about 22%, about 23%, about 24%, about 25%, about 26%, about 27%, about 28%, about 29%, about 30%, about 31%, about 32%, about 33%, about 34%, about 35%, about 36%, about 37%, about 38%, about 39%, about 40%, about 41%, about 42%, about 43%, about 44%, about 45%, about 46%, about 47%, about 48%, about 49%, about 50%, about 51%, about 52%, about 53%, about 54%, about 55%, about 56%, about 57%, about 58%, about 59%, about 60%, about 61%, about 62%, about 63%, about 64%, about 65%, about 66%, about 67%, about 68%, about 69%, about 70%, about 71%, about 72%, about 73%, about 74%, about 75%, about 76%, about 77%, about 78%, about 79%, about 80%, about 81%, about 82%, about 83%, about 84%, about 85%, about 86%, about 87%, about 88%, about 89%, about 90%, about 91%, about 92%, about 93%, about 94%, about 95%, about 96%, about 97%, about 98%, about 99%, or about 100%.

Clause 5. The method of clause 4a or clause 4b, wherein the first portion of the resin precursor mixture and the second portion of the resin precursor mixture are each independently characterized by a cure depth dimension.

Clause 6a. The method of clause 4a or clause 4b, wherein the overlap between the first portion of the resin precursor mixture and the second portion of the resin precursor mixture is between about 50% and 100%.

Clause 6b. The method of clause 4a or clause 4b, wherein the overlap between the first portion of the resin precursor mixture and the second portion of the resin precursor mixture is about 50%, about 51%, about 52%, about 53%, about 54%, about 55%, about 56%, about 57%, about 58%, about 59%, about 60%, about 61%, about 62%, about 63%, about 64%, about 65%, about 66%, about 67%, about 68%, about 69%, about 70%, about 71%, about 72%, about 73%, about 74%, about 75%, about 76%, about 77%, about 78%, about 79%, about 80%, about 81%, about 82%, about 83%, about 84%, about 85%, about 86%, about 87%, about 88%, about 89%, about 90%, about 91%, about 92%, about 93%, about 94%, about 95%, about 96%, about 97%, about 98%, about 99%, or about 100%.

Clause 7. The method of any one of clauses 1 to 6, wherein the resin precursor mixture has a viscosity before curing of 10 Pa·s or less.

Clause 8. The method of any one of clauses 1 to 7, wherein the resin precursor mixture comprises a first siloxane monomer, a first siloxane oligomer, or a first siloxane polymer, the siloxane comprising a plurality of thiol groups.

Clause 9. The method of any one of clauses 1 to 8, wherein the resin precursor mixture comprises a second siloxane monomer, a second siloxane oligomer, or a second siloxane polymer, the siloxane comprising a plurality of unsaturated carbon-carbon bonds.

Clause 10. The method of any one of clauses 1 to 9, wherein the resin precursor mixture comprises one or more of a photoinitiator and a catalyst.

Clause 11. The method of any one of clauses 1 to 10, wherein the resin precursor mixture comprises a non-reactive diluent.

Clause 12. The method of any one of clauses 1 to 11, wherein the resin precursor mixture comprises a thermochromic additive.

References:

"3D-printable thermochromic acrylic resin with excellent mechanical performance" Journal of Applied Polymer Science, (2019).
"Measuring UV curing parameters of commercial photopolymers used in additive manufacturing," Additive Manufacturing. (2017).

"Solution Mask Liquid Lithography (SMaLL) for One-Step, Multimaterial 3D Printing," Advanced Materials, (2018).

**Claims**

1. A method of 3D printing an object, comprising:

   providing a resin precursor mixture comprising a crosslinkable or polymerizable species, and a thermochromic species; and
   contacting a first portion of the resin precursor mixture with an actinic radiation;
   wherein upon contacting the portion of resin precursor mixture with the actinic radiation, a portion of the crosslinkable or polymerizable species in the resin precursor mixture cures to provide a portion of the object.

2. The method of claim 1, further comprising modulating the temperature of a second portion of the resin precursor mixture.

3. The method of claim 2, wherein the temperature is modulated by contacting the second portion of the resin precursor mixture with a thermal radiation.

4. The method of claim 2, wherein the first portion of the resin precursor mixture and the second portion of the resin precursor mixture are substantially overlapped.

5. The method of claim 4, wherein the first portion of the resin precursor mixture and the second portion of the resin precursor mixture are each independently **characterized by** a cure depth dimension.

6. The method of claim 4, wherein the overlap between the first portion of the resin precursor mixture and the second portion of the resin precursor mixture is between about 50% and 100%.

7. The method of claim 1, wherein the resin precursor mixture has a viscosity before curing of 10 Pa·s or less.

8. The method of claim 1, wherein the resin precursor mixture comprises a first siloxane monomer, a first siloxane oligomer, or a first siloxane polymer, the siloxane comprising a plurality of thiol groups.

9. The method of claim 1, wherein the resin precursor mixture comprises a second siloxane monomer, a second siloxane oligomer, or a second siloxane polymer, the siloxane comprising a plurality of unsaturated carbon-carbon bonds.

10. The method of claim 1, wherein the resin precursor mixture comprises one or more of a photoinitiator and a catalyst.

11. The method of claim 1, wherein the resin precursor mixture comprises a non-reactive diluent.

12. The method of claim 1, wherein the resin precursor mixture comprises a thermochromic additive.

Fig. 1

$T < T_{Thermochromic\ Transition}$

Small Cure Depth
High Resolution
Low Deposition Rate

Vat of Photopolymer Resin
(high absorptivity)

Printed Object

Light source

**Fig. 2A**

$T > T_{Thermochromic\ Transition}$

Large Cure Depth
Low Resolution
High Deposition Rate

Vat of Photopolymer Resin
(low absorptivity)

Printed Object

Light source

**Fig. 2B**

Europäisches
Patentamt
European
Patent Office
Office européen
des brevets

# EUROPEAN SEARCH REPORT

Application Number

EP 21 17 4427

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/087765 A1 (RUNDLETT BETH [US] ET AL) 30 March 2017 (2017-03-30) | 1-7, 10-12 | INV. G03F7/00 C08G77/28 G03F7/105 |
| Y | * claims 1-20 * | 8,9 | |
| X | WO 2011/091228 A1 (DSM IP ASSETS BV [NL]; FICEK BETH [US] ET AL.) 28 July 2011 (2011-07-28) | 1-7, 10-12 | |
| Y | * claims 1-18 * | 8,9 | |
| X | WO 2015/148613 A1 (DSM INTELLECTUAL PROPERTY ASSETS MANAGEM) 1 October 2015 (2015-10-01) | 1-7, 10-12 | |
| Y | * claims 1-20 * | 8,9 | |
| Y | WO 2018/026829 A1 (UNIV CORNELL [US]) 8 February 2018 (2018-02-08) * claims 1-18 * | 8,9 | |

TECHNICAL FIELDS
SEARCHED (IPC)

G03F
C08G

The present search report has been drawn up for all claims

| Place of search | Date of completion of the search | Examiner |
|---|---|---|
| Munich | 5 October 2021 | Mingam, Claudie |

EPO FORM 1503 03.82 (P04C01)

## ANNEX TO THE EUROPEAN SEARCH REPORT
## ON EUROPEAN PATENT APPLICATION NO.

EP 21 17 4427

This annex lists the patent family members relating to the patent documents cited in the above-mentioned European search report.
The members are as contained in the European Patent Office EDP file on
The European Patent Office is in no way liable for these particulars which are merely given for the purpose of information.

05-10-2021

| Patent document cited in search report | | Publication date | Patent family member(s) | | Publication date |
|---|---|---|---|---|---|
| US 2017087765 | A1 | 30-03-2017 | NONE | | |
| WO 2011091228 | A1 | 28-07-2011 | AU | 2011207304 A1 | 30-08-2012 |
| | | | CN | 102725689 A | 10-10-2012 |
| | | | EP | 2526463 A1 | 28-11-2012 |
| | | | JP | 5866686 B2 | 17-02-2016 |
| | | | JP | 2013517961 A | 20-05-2013 |
| | | | US | 2012295077 A1 | 22-11-2012 |
| | | | US | 2014235747 A1 | 21-08-2014 |
| | | | WO | 2011091228 A1 | 28-07-2011 |
| WO 2015148613 | A1 | 01-10-2015 | CN | 106132655 A | 16-11-2016 |
| | | | EP | 3122529 A1 | 01-02-2017 |
| | | | JP | 2017513729 A | 01-06-2017 |
| | | | WO | 2015148613 A1 | 01-10-2015 |
| WO 2018026829 | A1 | 08-02-2018 | US | 2020032062 A1 | 30-01-2020 |
| | | | WO | 2018026829 A1 | 08-02-2018 |

EPO FORM P0459

For more details about this annex : see Official Journal of the European Patent Office, No. 12/82

## REFERENCES CITED IN THE DESCRIPTION

**Patent documents cited in the description**

- US 63027247

**Non-patent literature cited in the description**

- 3D-printable thermochromic acrylic resin with excellent mechanical performance. *Journal of Applied Polymer Science,* 2019
- Measuring UV curing parameters of commercial photopolymers used in additive manufacturing. *Additive Manufacturing,* 2017

- Solution Mask Liquid Lithography (SMaLL) for One-Step, Multimaterial 3D Printing. *Advanced Materials,* 2018